**Europäisches Patentamt**

(19) **European Patent Office**

**Office européen des brevets**

(11) Publication number : **0 424 623 B1**

(12) # EUROPEAN PATENT SPECIFICATION

(45) Date of publication of patent specification :
**12.07.95 Bulletin 95/28**

(51) Int. Cl.[6] : **H01L 27/108,** H01L 27/102,
H01L 27/06, G11C 11/36

(21) Application number : **90115752.9**

(22) Date of filing : **17.08.90**

(54) **Three-dimensional semiconductor structures formed from planar layers.**

(30) Priority : **26.10.89 US 427679**

(43) Date of publication of application :
**02.05.91 Bulletin 91/18**

(45) Publication of the grant of the patent :
**12.07.95 Bulletin 95/28**

(84) Designated Contracting States :
**DE FR GB IT**

(56) References cited :
**EP-A- 0 176 078
EP-A- 0 295 709
DE-A- 2 628 435
FR-A- 1 418 764
US-A- 3 553 658**

(73) Proprietor : **International Business Machines
Corporation
Old Orchard Road
Armonk, N.Y. 10504 (US)**

(72) Inventor : **Pricer, Wilbur D.
58 Van Patten Parkway
Burlington, VT 05401 (US)**
Inventor : **Faure, Thomas B.
RFD. 3 Box 5273
Milton, VT (US)**
Inventor : **Meyerson, Bernard S.
235 California Road
Yorktown Heights, N.Y. 10598 (US)**
Inventor : **Turnbull, John R., Jr.
12 Governor's Lane
Shelburne, VT (US)**
Inventor : **Nestork, William, J.
Rd No. 1,
Box 1200
Hinesburg, VT 05461 (US)**

(74) Representative : **Schäfer, Wolfgang, Dipl.-Ing.
IBM Deutschland Informationssysteme GmbH
Patentwesen und Urheberrecht
D-70548 Stuttgart (DE)**

EP 0 424 623 B1

## Description

This invention relates to semiconductor devices, methods for their fabrication and, more particularly, to three-dimensional semiconductor memory structures and methods for providing sub-micron memory structures. The technology of producing semiconductor devices has been continually pressured to increase effective device densities in order to remain cost competitive. As a result, VLSI and ULSI technologies have entered the sub-micron realm of structural dimension and now are approaching physical limits in the nanometer feature size range. In the foreseeable future absolute atomic physical limits will be reached in the conventional two-dimensional approach to semiconductor device design. Traditionally, Dynamic Random Access Memory (DRAM) designers have faces the severest of challenges in advancing technologies. For example, designers of 64K DRAMs were perplexed to learn that a practical physical limit to charge capacity of storage capacitors had already been reached due to the minimum charge necessary to sense signals in the presence of environmental particulate radiation inherently present in fabrication materials. Storage capacitors in the range of 50 fF are now considered to be a physical limit. From a practical view, this limitation prevented the scaling of DRAM capacitors. Reduction of the surface area of a semiconductor substrate utilized by the storage capacitor has been severely restricted. Due to decreases in the thickness of capacitor materials, existing 1 Megabit (1Mb) DRAM technologies continue to enjoy the freedom of planar device and circuit design. Beginning with 4Mb DRAMs the world of three-dimensional design has been explored to the extent that the simple single device/capacitor memory cell has been altered to provide the capacitor in a vertical dimension. In such designs, the capacitor has been formed in a trench in the surface of the semiconductor substrate. In yet denser designs, other forms of capacitor design are proposed, such as stacking the capacitor above the transfer device. Additional designs have been proposed in which the device and its associated capacitor are formed within a trench of preferably minimum dimension.

While such design approaches appear to allow progressive increases in density in the near future, they are constrained by the limit of one memory cell per minimum photolithographic dimension. If semiconductor technology is to be extendable, design and process techniques are required which will enable full three-dimensional circuit design in which structural features are measured in nm and multiple circuit features are provided in the vertical dimension.

The world of three-dimensional semiconductor technology is not without precedent. For example, US-A-3 962 713 describes a three-dimensional capacitor structure formed by a series of vertical fins in the surface of a semiconductor substrate. The fins are oxidized and coated with a conductor to form the capacitor. US-A-4 827 323 describes a stacked capacitor for integrated circuit technology formed of a plurality of alternating conductor and dielectric layers in which alternate conductive layers are interconnected at their edges by a pair of vertical conductors.

Various additional 3-dimensional processing features are also known. For example, US-A-4 764 801 teaches the use of pillar-shaped vertical epitaxial and polysilicon regions interconnected by a plurality of substantially planar, isolated polysilicon layers to form various device structures. US-A-4 597 003 is also of interest, as it teaches semiconductor etching techniques for forming thin free-standing layers of n-type silicon on the opposite faces of a semiconductor wafer by the preferential etching of p-type semiconductor material.

Several 3-dimensional semiconductor device structures have been proposed with little or no process or fabrication detail. Both US-A-4 794 442 and EP-A-0 073 486 are examples. The former describes 3-dimensional semiconductor structures formed without metals or insulators through the use of molecular beam deposited epitaxial layers and regions. Device sizes rival conventional planar devices and have dimensions in the 10+ $\mu$m range. The latter describes the formation of a multi-level DRAM formed of slabs of semiconductor material including a plurality of memory cells and circuit interconnection means stacked to form a cube-like structure.

Additional three-dimensional semiconductor structures have been described. For example, US-A-4 675 980 describes a layered device in which layers of insulator and metal are used to form a MOMOM tunnel device. US-A-4 763 179 describes a DRAM cell in which a buried capacitor is formed by enlarging a trench below the surface of a semiconductor wafer by the selective etching of a dopant introduced into the trench.

It is an object of this invention to enable the formation of physically delineated three-dimensional technological segments having dimensions of less than 100 nm.

It is a further object of this invention to provide semiconductor device structures including a plurality of substantially horizontal trench-like regions connected to a common vertical trench.

It is another object of this invention to provide methods for fabricating physical device structures having dimensions determined by deposition techniques enabling three-dimensional structures in the 100 nm range.

It is yet another object of this invention to provide semiconductor structures fully compatible with three-dimensional circuit design.

These objects are achieved by a semiconductor device and a method of its manufacture as defined by the appended claims.

EP-A-0295709 describes a dynamic random access memory device including a storage capacitor having a plurality of stacked conductive films which form a storage electrode. A gap is formed between elevationally adjacent conductive films so as to surround the storage electrode. A gap is formed between an insulating film which covers a gate electrode for insulation and a lower-most film of the storage electrode. Connection between the adjacent films is established so that an uppermost film elevationally extends so as to make contact with a drain region. Also, connection can be established so that an upper film is mounted directly on a lower film. An end portion of the film is thicker than the other portion thereof. The stacked film structure may be produced by alternatively forming a film made of a material different from the insulating film covering the gate electrode, and a conductive film.

EP-A-0176078 for example discloses an integrated circuit formed as a multilayered structure of deposited layers of various materials, including semiconductor alloy materials. The layers of semiconductor alloys are initially deposited as continuous layers. The layers are arranged to provide semiconductor interactions, such as series coupled back-to-back diodes, between at least some of the layers at several unique locations within the structure, and to provide programmable interactions in two separate subsets, each separately programmable from the other.

Ways of carrying out the invention are described in detail below with reference to drawings in which:

| | |
|---|---|
| Fig.1 | is a sectional view of an example, useful for understanding the invention but not belonging to the invention as claimed, showing the location of planar layers for forming a capacitor above active circuits on a semiconductor wafer; |
| Fig. 2 | is an enlarged sectional view of a portion of a capacitor showing details of fabrication; |
| Fig. 3 | is a schematic circuit diagram illustrating a preferred embodiment of a DRAM according to the invention ; |
| Fig. 4 | is a circuit diagram of a preferred memory cell for use in implementing the invention; |
| Fig. 5 | is a plan view of a pattern of memory cell stacks formed on the top surface of a semiconductor wafer; |
| Figs. 6 and 7 | are sectional views showing partially fabricated stacked memory cells of the circuit of Fig. 3; |
| Figs. 8 through 13 | are sectional views of another example useful for understanding the invention illustrating the sequence of steps utilized in fabrication of a DRAM cell; |
| Fig. 14 | is a plan view of the mask pattern useful in forming an etch monitor for use in fabricating the memory cells of Figs. 8-13; |
| Figs. 15 and 16 | are embodiments as fabricated in silicon semiconductor wafers. |

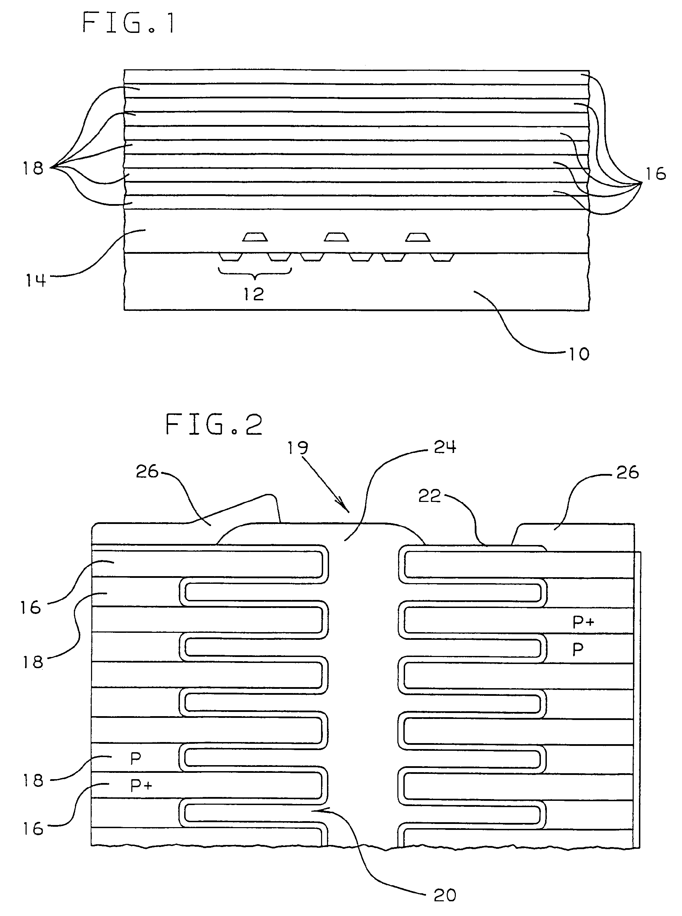

Referring to Fig. 1, there is shown a sectional view of a capacitor. On a semiconductor substrate 10 there are a plurality of FET devices 12 formed by any conventional FET fabrication process. After formation of the basic device structures and their interconnection metallurgy, a planarized layer of insulator 14 is formed by any of a number of deposition and etch-back techniques, such as RIE etching of a polymer layer or the chemical-mechanical polishing of the substrate. Next, a plurality of alternating heavily doped and lightly doped silicon layers 16 and 18 are formed on the substantially planarized surface. The thickness of the polysilicon layers is preferred to be from about 50 to 250 nm. Impurity concentration of the heavily doped layers is preferred to be about 1.5 E 20 atoms per cubic centimeter, where "E xx" represents 10 to the xx power. Boron is the preferred p-type dopant.

Referring to Fig. 2, after the formation of the doped and undoped layers, standard photolithographic process steps are used to form a hexagonal pattern of small vertical trenches 19 completely through the multiplane laminate. An anisotropic etchant which preferentially reacts with the lightly doped silicon is applied to etch the lightly doped silicon to form a plurality of disk-shaped secondary regions or trenches 20 in the laminate region. The preferred etchant is described below at the discussion of the preferred embodiment. The etch ratio between undoped and heavily doped silicon is about 450:1. Next, a blocking mask is applied to establish one or more capacitor islands on the substrate. The edges of these islands are directionally etched down to the top of planarized interlevel dielectric 14. A thin capacitor dielectric layer 22 is formed by chemically depositing a thin oxy-nitride dielectric layer of about 15 nm on all surfaces of the exposed polysilicon laminate. Trapped charge in the laminate is removed by annealing at about 800°C for about 30 minutes. Next, boron doped polysilicon 24 is conformably deposited on all exposed silicon. On the top surface, polysilicon patterns 26 are formed to provide fuses in series with each capacitor. At the surface, the polysilicon fuses are formed such that they have a resistance of about 500 Ω. Upon application of power, should any of the capacitor structures contain a defect which causes a short between conductive layers, the polysilicon fuse will open to isolate the capacitor from the remainder of the circuitry. Each capacitor is designed to have a capacitance of about 740 fF. The time constant of such a capacitor is:

500 X 740xE-15 = 0.37 ns.

Based on parameters given above, each mm$^2$ of capacitor structure will provide about 24 nF of capacitance. The semiconductor surface area under the capacitors can be used for various conventional functions as long as no metallurgical contacts are required. Capacitors can be fabricated as individual elements, or as serial or distributed capacitances. The series inductance is in the sub-pH range. Application of such capacitors is in the areas of power supply filtering and signal processing.

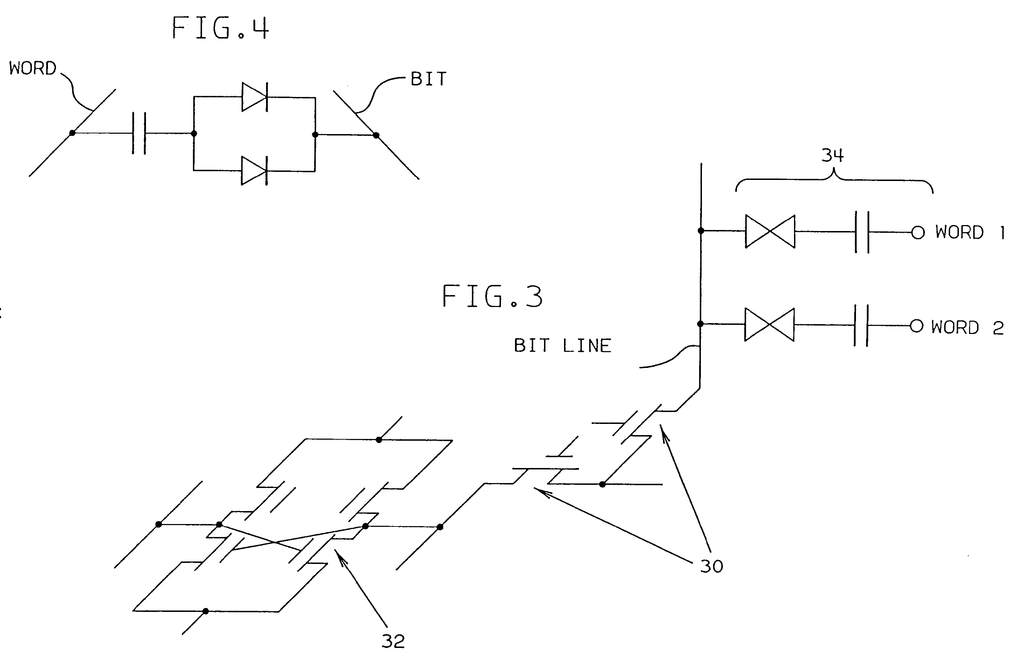

Referring to Figs. 3-7 there is shown a preferred embodiment of the invention in which an array of DRAM cells is formed within the interior regions of the horizontal trenches formed in the laminated layers.

Referring briefly to Fig. 3, there is shown a schematic view of the circuitry for the DRAM. In the surface of a semiconductor wafer conventional memory array support circuits including buffering, decoding circuits 30 and sensing circuits 32 are fabricated preferably in CMOS FET technology. These circuits are disposed on the substrate in a generally horizontal plane in the same manner as in contemporary DRAM design. The memory array of the invention is, however, disposed in a substantially vertical direction perpendicular to the support circuits. The dynamic memory cells 34 are preferred to be of the type described in commonly assigned US-A-3 553 658. The schematic circuit equivalence of the memory cell is shown in Fig. 4. The cell operates in a manner similar to that of the conventional one-device memory cell.

Fabrication of the three-dimensional storage array begins with the planarization of the semiconductor substrate containing the support circuitry. It is also contemplated that the laminated array structure can be fabricated as a separate item and then coupled to the support bearing substrate by well known bonding techniques. In either case alternating layers of two different materials are deposited preferably by Chemical Vapor Deposition (CVD) with or without plasma excitation. The materials required for this embodiment are a conductor, preferably doped polysilicon, and an insulator, preferably an oxide/nitride combination. In order to accommodate the array of binary addressable memory cells contemplated, the number of conductive layers should be a power of 2. As an example, the number of layers can be 16. The thickness of each layer is a design choice and is on the order of 50 to 500 nm.

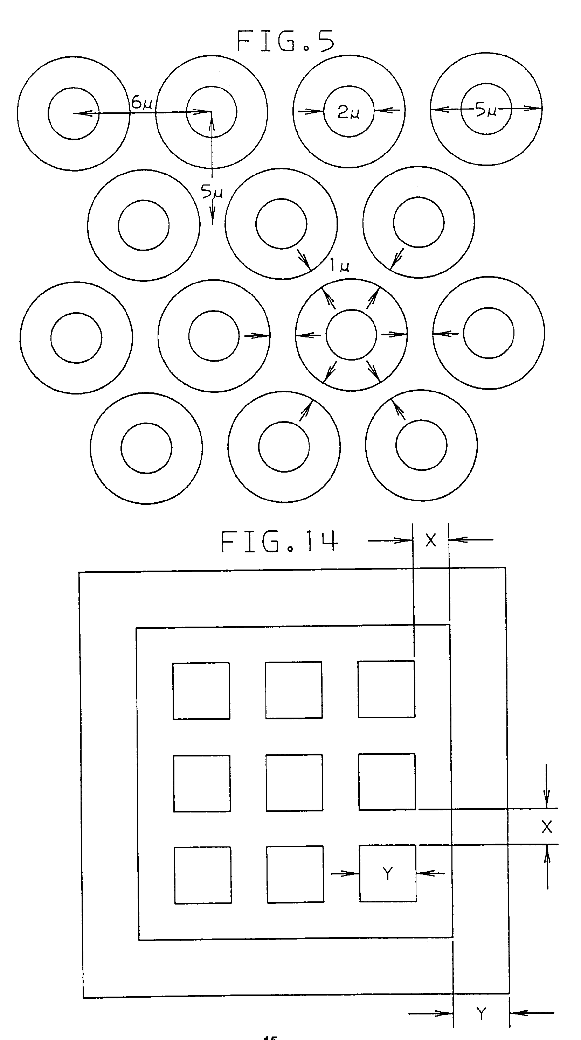

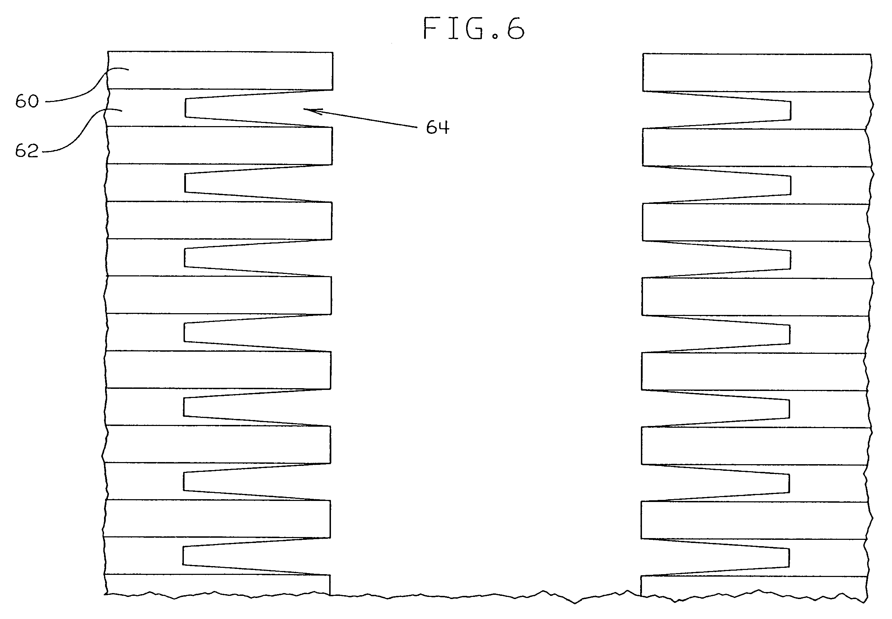

Following deposition of the layers, 16 planes of doped polysilicon and 17 layers of insulator will have been deposited. In order to form the memory cells, a mask is applied to the top surface of the laminate to define within the plane of the array a plurality of vertical regions perpendicular to the plane of the substrate. Apertures in the mask, shown in Fig. 5, are best placed in a hexagonal pattern for maximum density. In this embodiment, cells are spaced at a horizontal pitch of 6 μm and a vertical pitch of 5 μm. The actual mask pattern used is represented by the smaller diameter circles shown and indicated as being of a diameter of 2 μm. Next a highly directional anisotropic etching process is used to produce an array of holes penetrating all of the layers of the laminate. Fig. 6 is illustrative of the cross section of a single hole of the laminate showing only the top region of the hole. The specific etching process may vary depending on the exact materials chosen. For example, Reaction Ion Etching (RIE) utilizing silicon tetrafluoride and chlorine as described in US-A-4 264 409. It may be desirable to use alternating etching atmospheres to anisotropically etch the alternating layers of oxide 60 and silicon 62.

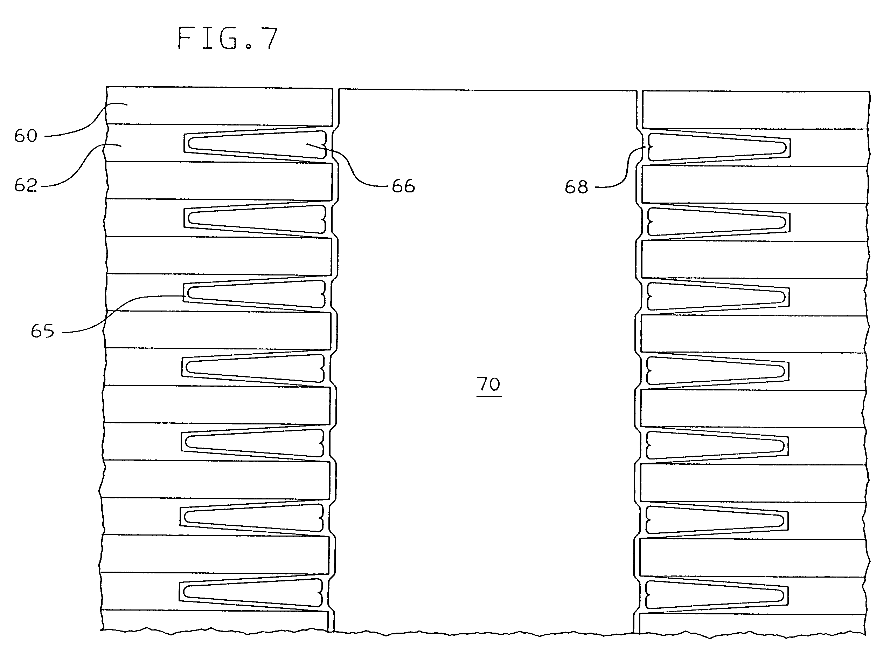

Following the etching of the vertical holes in the laminate, a selective silicon isotropic etchant such as one containing tetramethylammonium hydroxide, as taught in US-A 4 113 551 can be used. The result is to provide a series of horizontal trenches 64 in the laminate parallel to the surface of the supporting substrate and substantially bounded by oxide layers 60. Next, referring to Fig. 7, the exposed surface of the polysilicon layers is oxidized to form a MOS capacitor dielectric layer having a minimal thickness required for reliable operation. A conformal Chemical Vapor Deposition (CVD) step fills the horizontal trenches with conductive polysilicon 66. A second anisotropic etch is performed to remove silicon from within the vertical portions of the contact holes leaving portions of polysilicon 66 within the horizontal trenches. This is followed by the formation of a region of non-linear barrier layer material 68, such as a pn junction, at the inside ends of each of the polysilicon plugs 66 now filling the horizontal portions of the trenches. The non-linear material acts as the transfer device in the memory cell of previously identified US-A-3 553 658. Finally, a conductive filler or plug 70 is formed within the vertical trench to interconnect all of the non-linear regions to a common data bus. This completes the array of storage cells. Each cell is coupled to bit line 70 via the non-linear material and the word line conductor 62 via dielectric 65.

Connection to the vertical bit line segments is made directly to the plane containing the support circuits. Connection to the word line segments is somewhat more difficult since the word lines need to be accessed independently. This may be accomplished by utilizing a multilayered terraced arrangement, around the outside of the stacked capacitor arrays. The exposed conductive layers allow access to the individual word lines by conformal layers appropriately personalized along the stair steps of the terraces. Alternately, an access via, formed in a similar manner to the bit line segment trenches, can be used to contact the various word line segments.

Because the capacitance between word lines of the array would be considerable, the exterior portions of the array stacks can be removed leaving the active arrays in the pattern of a waffle grid.

The memory array described here has the potential of providing 16 times the storage density as known DRAM array designs, as the surface area required for each cell in the plane of the substrate is shared by 16 cells in the example given. The three-dimensional array operates by the 2 1/2 D selection scheme analogous to magnetic core technology. In order to render the non-linear material conductive it is necessary to place selection signals on both the word and bit lines.

For purposes of illustration, let it be assumed that the non-linear material operates as a pair of back-to-back diodes with a forward bias Vf of 2.5 V. The following table illustrates the signals required to operate the cell as a single bit storage medium. Entries separated by "," represent two possible signals which are a function of the data being stored or read.

```
Condition        Vword              Vstored             Vbit

Rest             +2.5               +2.5,   0            0

Before Read
   Selected      +2.5               +2.5,   0           +2.5
   Unselected    +2.5               +2.5,   0            0

Read
   Selected        0                  0               +2.5-Signal
   Unselected    +2.5               +2.5,   0            0

Before Write
   Selected      +2.5               +2.5                +2.5,  0
   Unselected    +2.5               +2.5,   0           +2.5

Write
   Selected      +5.0               +5.0,  +2.5         +2.5,  0
   Unselected    +2.5               +2.5,   0           +2.5
```

Other drive voltages would be appropriate depending on the I/V characteristics of the non-linear material. In general, the non-linear material must exhibit about five orders of magnitude current change.

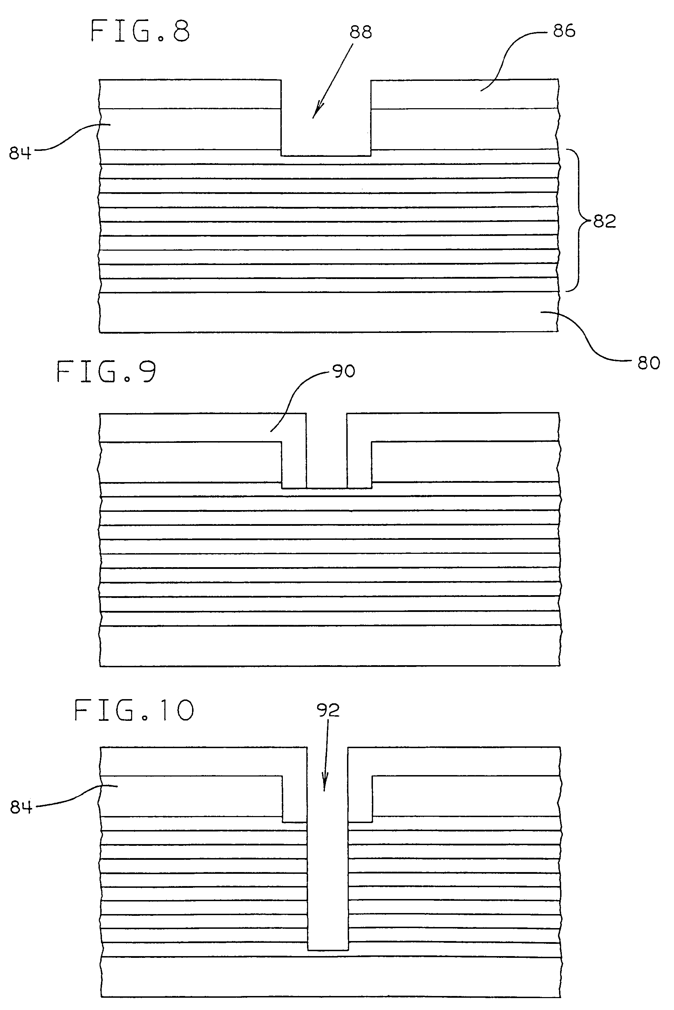

Shown in conjunction with Figs. 8-13 is a further example of the laminated structures as embodied in another application to DRAM technology, the example being useful for understanding the invention but not belonging to the invention as claimed. Here a less aggressive design approach is illustrated in which a single dynamic DRAM cell is fabricated with enhanced capacitance. It has been demonstrated in EP-A-0 259 759 corresponding to US-A-906 854 filed December 9, 1986, now abandoned, that extremely high quality crystalline layers of semiconductor material can be deposited in layers as thin as a few ten nm by Ultra High Vacuum Chemical Vapor Deposition (UHV/CVD). Referring to Fig. 8 there is shown a cross-section view of a silicon semiconductor substrate comprising a substantially planar supporting substrate region 80 having a surface parallel to a predefined plane. The substrate is heavily doped with boron on which has been epitaxially deposited a plurality of extremely thin layers 82 of alternately heavy and lightly doped, or intrinsic, silicon. The number of layers is not critical as with the preferred embodiment and can be any convenient number. In order to facilitate the etching in subsequent processing steps, it is preferred that the top thin layer be fabricated as heavily doped. The thickness of each layer is preferred to be in the nm range or about 10 to 50 nm.

The formation of p/p+ or intrinsic/p+ layers proceeds as follows. Silicon substrates are cleaned in (Huang) acid/hydroxide reagent, etched for 10 seconds in 10:1 Hydrofluoric acid and placed in the UHV/CVD apparatus load lock. After vacuum transfer to within the reactor, the substrates, maintained at about 550°C, are exposed to the flow of reactive gases. For intrinsic silicon, only silane is flowed. For heavily doped layers, silane plus 1% diborane is flowed. At processing temperatures of 450-650°C, growth rate is on the order of 0.3-3 nm per minute. Reactor pressure during deposition is maintained at approximately 1,33 µbar. Resulting layers of silicon have doping of less than 1E17 B/cm$^3$ and 5E21 B/cm$^3$ as determined by SIMS analysis.

The topmost layer 84 is substantially thicker than the other layers, as it will be required to support conventional CMOS support circuitry, and should be about 500 to 1500 nm in thickness. A layer of thick masking dielectric such as silicon dioxide 86 is deposited and using a photolithographic, or X-ray responsive, masking layer, apertures 88 are formed using a minimum or near minimum geometry in the dielectric layer. Next, a conformal dielectric layer is blanket deposited, partially filling the etched hole in dielectric layer 86. A highly directional RIE etching process is used to remove portions of the conformal layer from the horizontal surfaces only leaving portions 90 of the layer on the sidewalls of the etched apertures. As shown in Fig. 9, sub-lithographic holes remain. Next a silicon selective RIE process is used to form a vertical trench through the thin epitaxial layers. As shown in Fig.10, the trench 92 can be extended for several μm through the layers.

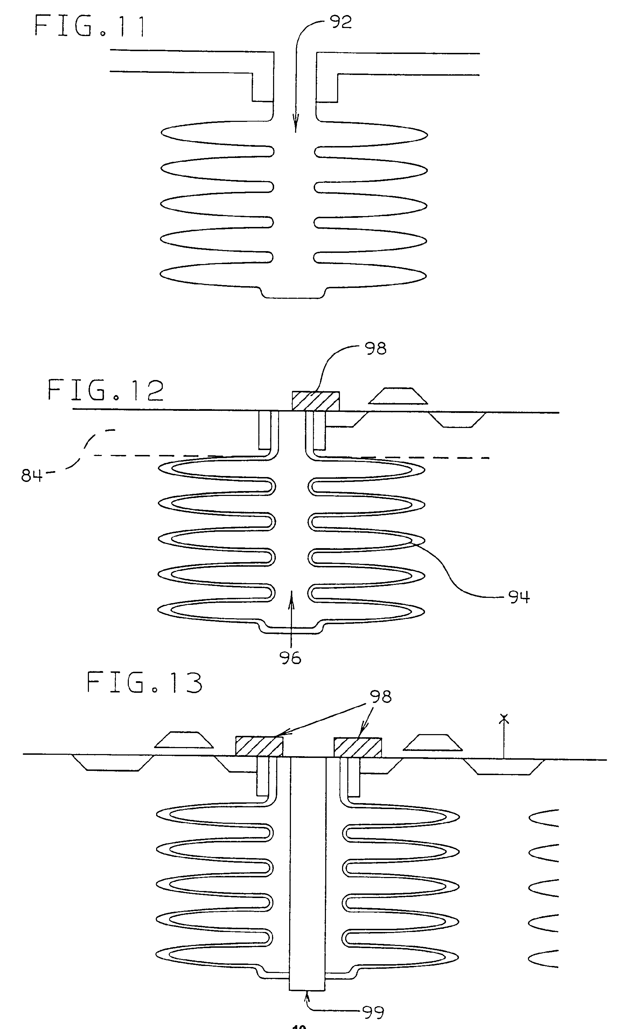

After formation of the vertical trenches, the substrate is subjected to an etchant highly selective to heavily doped silicon, for example an ethylenediamine, pyrocatechol, water solution. This step causes the formation of a plurality of trenches orthogonal to the vertical trench 92, as shown in Fig. 11.

An alternative etchant is Nitric Acid/HF (200:1) at room temperature. This composition is effective for relatively thick (60 nm fin, 130 nm space) layers where p+ doping is on the order of $4E21/cm^3$.

Following the formation of the horizontal trenches, a conformal layer of dielectric 94 suitable for the insulator of a storage capacitor is provided on all exposed areas of silicon. Next, a conformal conductive layer 96 is formed over the dielectric layer and may fill the vertical trench. The conductive layer may by doped polysilicon or metal. This completes the formation of the storage capacitor.

The memory cell is completed by the formation of planar MOS access transistor as shown in Fig. 12. In order to enable the stored data signal to be placed on the capacitor, a surface strap 98 is formed between the storage node and the diffused region of the planar device on the surface of layer 84.

In an alternative example, the storage capacitor of Fig. 12 can be designed to support two capacitors by forming a dielectric filled trench 99 in the center of the cell in a manner similar to the sidewall technique used to form the vertical trench in Fig. 10. A cross-section of such a structure is illustrated in Fig. 13.

In a final embodiment, the etching of the horizontal trenches is facilitated by the use of a highly anisotropic etchant which has the capability of selectively etching along certain crystalline planes.

The use of an anisotropic etchant has the added advantage of providing rectangular etched regions as viewed in the plane of the substrate surface. This enables the design of much more closely packed memory cells across the surface of the substrate.

The preferred anisotropic etchant is described in application US-A-416 377 and comprises:

| | |
|---|---|
| Ethanolamine | 3830 ml |
| Gallic Acid | 1150 ml |
| Water | 1200 ml |
| Pyrazine | 25 g |
| Hydrogen Peroxide (30%) | 10 ml |
| FC 129 (1%) | 100 ml |

Etching times between 120 and 600 s are recommended depending on the length of horizontal penetration desired. The anisotropic etching was preceded by a 10 s buffered HF dip to remove any "native oxide" which may be present.

In order to obtain maximum packing density, it is necessary to place adjacent 3-dimensional structures as close as possible to each other without causing one structure to interfere with another.

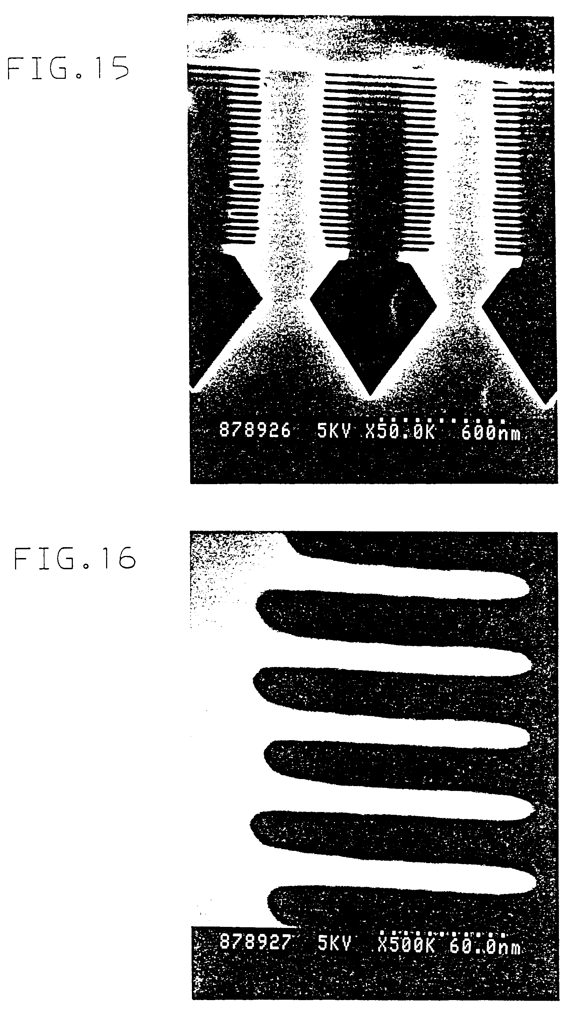

An etch monitor has been developed, as shown in Fig. 14, which enables precise control over the extent of lateral etching of the horizontal trenches. The monitor includes the pattern shown in the figure where the dimension Y equals dimensions used in the array area to define vertical trenches, etc. The dimension X is smaller than the comparable dimension in the non-monitor or array portion of the substrate by about a tenth of a micron in order to place the structures in the monitor closer to each other than their counterparts in the array. During the etching process, when the etchant has etched the horizontal distance X, in the monitor, portions of the monitor will delaminate and float away from the surface of the semiconductor wafer. This condition is easily monitored manually or by the use of an optical apparatus.

Figs. 15 and 16 illustrate cross-sectional views of etched semiconductor wafers in which the thickness of the epitaxial layers is in the range of 20 to 40 nm. The dark portions of the Figs. represent the regions in which silicon has been removed. Fig. 15 illustrates portions of three etched regions. Fig. 16 is an enlarged view of the finlike lightly doped silicon remaining after the etching.

## Claims

1.   A semiconductor DRAM device comprising:
a substantially planar substrate (10) including a surface having an orientation parallel to a first plane;
a plurality of first planar regions (60) of a first material formed in vertical spaced relationship to and above said surface;

a plurality of second planar regions (62) of conductive material formed above said surface, each second planar region vertically interleaved between adjacent first planar regions (60) and forming word lines;

a plurality of third planar regions (64) formed laterally adjacent to said second planar regions and vertically between adjacent first planar regions, said third regions (64) being defined substantially by said first material;

a conductive member (66) at least partially filling each said third region, said conductive member being insulatingly spaced from said first and second planar regions; and

at least one connecting region, passing substantially orthogonally through at least some of said first regions (60) and adjacent to said third regions (64), said connecting region including at least one bit line (70), said bit line in said connecting region being electrically coupled to the conductive member (66) within the third regions (64) by at least one region of nonlinear barrier layer material (68) operating as a pair of back-to-back diodes, wherein said at least one bit line (70) interconnects all of the regions of non-linear barrier layer material (68) to a common data bus and wherein each said conductive member (66) within said third region (64) is accessed independently by respective word lines (62).

2. The semiconductor device of claim 1 wherein said bit line (70) in said connecting region is connected to at least one semiconductor switching device formed as a part of a semiconductor memory accessing circuit.

3. The semiconductor device of claim 2 wherein said switching device is connected to the end of said bit line (70) farthest from said surface of said substrate.

4. The semiconductor device of one or more of the preceding claims 1 to 3 wherein said connecting region exhibits mirror symmetry about an axis orthogonal to said first plane and said third regions exhibit rotational symmetry about said axis.

5. The semiconductor device of one or more of the preceding claims 1 to 3 wherein said first material comprises a semiconductor material comprising silicon.

6. The semiconductor device of one or more of the preceding claims 1 to 5 wherein said first region (60) comprises heavily doped semiconductor material and said second region (62) comprises substantially intrinsic or lightly doped semiconductor material, wherein said semiconductor material comprises crystalline silicon.

7. The semiconductor device of claim 6 wherein said semiconductor material is doped with p-type impurity comprising boron.

8. The semiconductor device of one or more of the preceding claims 1 to 7 wherein the thicknesses of said first (60) and second regions (62) are less than about 100 nm.

9. The semiconductor device of one or more of the preceding claims 1 to 8 wherein the extent of said third regions (64) between said adjacent first planar regions (60) is more than ten times the thickness of said second regions (62).

10. The semiconductor device of one or more of the preceding claims 1 to 8 wherein said substrate (10) includes a crystalline semiconductor substrate oriented such that said first plane is parallel to the <100> plane of said substrate (10).

11. The semiconductor device of one or more of the preceding claims 1 to 10 wherein said first and second materials are crystalline semiconductor material epitaxially formed on said substrate (10) and said third regions (64) include boundaries terminating on <111> planes.

12. A method of making a three dimensional semiconductor DRAM device according to one or more of the preceding claims 1 to 11 on the surface of a substrate (10) wherein the surface is parallel to a first plane comprising the steps of:

forming a plurality of first (60) and second (62) interleaved layers of a first and second material on said surface parallel to said first plane said second layers forming word lines;

forming a connecting region through said layers (60, 62) by penetrating said layers substantially orthogonally to said first plane;

forming trench-like regions (64) in said second layers (62) substantially parallel to said first plane by selectively etching said second layers (62) substantially to the exclusion of said first layers (60);

providing a dielectric material (65) on the surfaces of said trench-like regions (64);

filling said trench-like regions (64) with conductive material (66), forming a region of non-linear barrier layer material (68) at the exposed ends of the conductive material thus forming semiconductor device structures within said regions;

forming a bit line (70) within said connecting region to enable said semiconductor device structures within said trench-like regions (64) to be electrically connected to portions of said substrate (10) outside of said first and second layers (60, 62);

making contacts to word lines to enable said semiconductor device structures to be accessed independently.

13. The method of claim 12 wherein the step of forming a plurality of first (60) and second layers (62) includes depositing alternating insulator and semiconductor layers comprising the epitaxial deposition of said layers and the ultra low pressure chemical vapor deposition of said layers with a deposition pressure less than 1.33 µbar.

14. The method of claim 12 or 13 wherein the step of forming trench-like regions (64) is performed using an anisotropic etchant to selectively etch said second layers (62) substantially to the exclusion of said first layers (60).

15. The method of one or more of the preceding claims 12 to 14 wherein the step of forming a connecting region comprises a highly directional anisotropic etching process like reactive ion etching.

16. The method of one or more of the preceding claims 12 to 15 including the formation of a plurality of connecting regions and further including the formation of an etch monitor region for enabling the determination of the extent to which the trench-like regions (64) are formed in said second layers (62).

17. The method of claim 16 wherein at least one of the connecting regions is associated with the monitor region such that the monitor comprises a three dimensional trench structure substantially identical to other connecting regions wherein at least one dimension is less than a counterpart dimension in the non-monitor portion of the structure.

## Patentansprüche

1. Halbleiter-DRAM-Bauelement umfassend:

ein im wesentlichen planares Substrat (10), das eine Oberfläche mit einer Orientierung parallel zu einer ersten Ebene einschließt;

eine Mehrzahl erster planarer Bereiche (60) eines ersten Materials, das in einem vertikalen Abstand zu der Oberfläche und über der Oberfläche gebildet wird;

eine Mehrzahl zweiter planarer Bereiche (62) eines leitenden Materials, das über der Oberfläche gebildet wird, wobei jeder zweite planare Bereich vertikal zwischen benachbarten ersten planaren Bereichen (60) verschachtelt ist und Wortleitungen bildet;

eine Mehrzahl dritter planarer Bereiche (64), die seitlich benachbart zu den zweiten planaren Bereichen und vertikal zwischen benachbarten ersten planaren Bereichen gebildet werden, wobei die dritten Bereiche (64) im wesentlichen durch das erste Material festgelegt werden;

ein leitendes Teil (66), das zumindest teilweise jeden dritten Bereich füllt, wobei das leitende Teil einen isolierenden Abstand von den ersten und zweiten planaren Bereichen aufweist; und

mindestens einen Verbindungsbereich, der im wesentlichen orthogonal durch mindestens einige der ersten Bereiche (60) und benachbart zu den dritten Bereichen (64) verläuft, wobei der Verbindungsbereich mindestens eine Bitleitung (70) einschließt, die Bitleitung in dem Verbindungsbereich elektrisch mit dem leitenden Teil (66) innerhalb der dritten Bereiche (64) durch mindestens einen Bereich eines nicht-linearen Sperrschichtmaterials (68), das als ein Paar antiparallel geschalteter Dioden arbeitet, verbunden ist, wobei mindestens eine Bitleitung (70) alle Bereiche des nichtlinearen Sperrschichtmaterials (68) mit einem gemeinsamen Datenbus verbindet und wobei auf jedes der leitende Teile (66) innerhalb des dritten Bereichs (64) unabhängig durch entsprechende Wortleitungen (62) zugegriffen wird.

2. Halbleiterbauelement nach Anspruch 1, wobei die Bitleitung (70) in dem Verbindungsbereich mit mindestens einem Halbleiterschaltelement verbunden ist, das als ein Teil einer Halbleiterspeicher-Zugriffsschaltung gestaltet ist.

3. Halbleiterbauelement nach Anspruch 2, wobei das Schaltbauelement mit dem Ende der Bitleitung (70), das am weitesten von der Oberfläche des Substrats weg ist, verbunden ist.

4. Halbleiterbauelement nach einem oder mehreren der vorhergehenden Ansprüche 1 bis 3, wobei der Verbindungsbereich eine Spiegelsymmetrie zu einer orthogonal zu der ersten Ebene liegenden Achse zeigt und die dritten Bereiche eine Rotationssymmetrie zu der Achse zeigen.

5. Halbleiterbauelement nach einem oder mehreren der vorhergehenden Ansprüche 1 bis 3, wobei das erste Material ein siliciumhaltiges Halbleitermaterial umfaßt.

6. Halbleiterbauelement nach einem oder mehreren der vorhergehenden Ansprüche 1 bis 5, wobei der erste Bereich (60) hochdotiertes Halbleitermaterial und der zweite Bereich (62) im wesentlichen intrinsisches oder niedrigdotiertes Halbleitermaterial umfaßt, wobei das Halbleitermaterial kristallines Silicium umfaßt.

7. Halbleiterbauelement nach Anspruch 6, wobei das Halbleitermaterial mit einer borhaltigen Verunreinigung des p-Typs dotiert ist.

8. Halbleiterbauelement nach einem oder mehreren der vorhergehenden Ansprüche 1 bis 7, wobei die Dicken der ersten (60) und zweiten Bereiche (62) weniger als 100 nm sind.

9. Halbleiterbauelement nach einem oder mehreren der vorhergehenden Ansprüche 1 bis 8, wobei die Ausdehnung der dritten Bereiche (64) zwischen den benachbarten ersten planaren Bereichen (60) mehr als das Zehnfache der Dicke der zweiten Bereiche (62) ist.

10. Halbleiterbauelement nach einem oder mehreren der vorhergehenden Ansprüche 1 bis 8, wobei das Substrat (10) ein kristallines Halbleitersubstrat einschließt, das derart orientiert ist, daß die erste Ebene parallel zur <100> Ebene des Substrats (10) ist.

11. Halbleiterbauelement nach einem oder mehreren der vorhergehenden Ansprüche 1 bis 10, wobei das erste und zweite Material epitaxial auf dem Substrat (10) gewachsenes kristallines Halbleitermaterial ist und die dritten Bereiche (64) Grenzflächen, die durch <111> Ebenen abgeschlossen werden, einschließen.

12. Verfahren zur Herstellung eines dreidimensionalen Halbleiter-DRAM-Bauelements gemäß einem oder mehreren der vorhergehenden Ansprüche 1 bis 11 auf der Oberfläche eines Substrats (10), wobei die Oberfläche parallel zu einer ersten Ebene ist, das folgende Schritte umfaßt:
Bilden einer Mehrzahl erster (60) und zweiter (62) ineinander verzahnter Schichten aus einem ersten und einem zweiten Material auf der Oberfläche parallel zu der ersten Ebene, wobei die zweiten Schichten Wortleitungen bilden;
Bilden eines Verbindungsbereichs durch die Schichten (60, 62), im wesentlichen orthogonal zu der ersten Ebene, mittels Durchdringen der Schichten;
Bilden von grabenartigen Bereichen (64) in den zweiten Schichten (62) im wesentlichen parallel zu der ersten Ebene durch selektives Ätzen der zweiten Schichten (62) im wesentlichen unter Ausschluß der ersten Schichten (60);
Bereitstellen eines dielektrischen Materials (65) auf den Oberflächen der grabenartigen Bereiche (64);
Füllen der grabenartigen Bereiche (64) mit leitendem Material (66), Bilden eines Bereichs eines nichtlinearen Sperrschichtmaterials (68) an den freiliegenden Enden des leitenden Materials und somit Bilden von Halbleiterbauelementstrukturen innerhalb dieser Bereiche;
Bilden einer Bitleitung (70) innerhalb des Verbindungsbereichs, um zu ermöglichen, daß die Halbleiterbauelementstrukturen innerhalb der grabenartigen Bereiche (64) mit Teilen des Substrats (10) außerhalb der ersten und zweiten Schichten (60, 62) elektrisch verbunden werden;
Herstellen von Kontakten zu Wortleitungen, um zu ermöglichen, daß auf die Halbleiterbauelementstrukturen unabhängig zugegriffen werden kann.

13. Verfahren nach Anspruch 12, wobei der Schritt des Bildens einer Mehrzahl von ersten (60) und zweiten (62) Schichten ein alternierendes Abscheiden von Isolator- und Halbleiterschichten einschließt, das epitaxiale Abscheidung der Schichten und chemische Gasphasenabscheidung der Schichten unter Ultra-Niederdruck mit einem Abscheidedruck von weniger als 1,33 μbar umfaßt.

14. Verfahren nach Anspruch 12 oder 13, wobei der Schritt des Bildens der grabenartigen Bereiche (64) unter Verwenden eines anisotropen Ätzmittels durchgeführt wird, um selektiv die zweiten Schichten (62) im wesentlichen unter Ausschluß der ersten Schichten (60) zu ätzen.

15. Verfahren nach einem oder mehreren der vorhergehenden Ansprüche 12 bis 14, wobei der Schritt des Bildens eines Verbindungsbereichs ein stark richtungsabhängiges anisotropes Ätzverfahren, wie das reaktive Ionenätzen, umfaßt.

16. Verfahren nach einem oder mehreren der vorhergehenden Ansprüche 12 bis 15, das die Bildung einer Mehrzahl von Verbindungsbereichen einschließt und das weiterhin die Bildung einer Ätzkontrollzone umfaßt, die die Bestimmung der Ausdehnung ermöglicht, bis zu der die grabenartigen Bereiche (64) in den zweiten Schichten (62) ausgeformt werden.

17. Verfahren nach Anspruch 16, wobei mindestens einer der Verbindungsbereiche zu einer Ätzkontrollzone gehört, so daß die Kontrolle eine dreidimensionale Grabenstruktur umfaßt, die im wesentlichen mit den anderen Verbindungsbereichen identisch ist, wobei mindestens eine Abmessung geringer ist, als die Abmessung eines Gegenstücks in einem nichtkontrollierten Abschnitt der Struktur.


## Revendications

1. Un dispositif DRAM semiconducteur comprenant:
   - un substrat pratiquement plan (10) comprenant une surface dont l'orientation est parallèle à un premier plan;
   - une pluralité de premières régions planes (60) d'un premier matériau formées avec un espacement vertical au dessus de ladite surface;
   - une pluralité de deuxièmes régions planes (62) de matériau conducteur formées au dessus de ladite surface, chaque deuxième région plane étant verticalement imbriquée entre des premières régions planes adjacentes (60) et formant des lignes de mots;
   - une pluralité de troisièmes régions planes (64) formées latéralement adjacentes auxdites deuxièmes régions planes et verticalement entre des premières régions planes adjacentes, lesdites troisièmes régions (64) étant pratiquement définies par ledit premier matériau;
   - un élément conducteur (66) remplissant au moins partiellement chacune desdites troisièmes régions, ledit élément conducteur étant séparé et isolé desdites premières et deuxièmes régions planes; et
   - au moins une région de connexion passant pratiquement orthogonalement au travers d'au moins certaines desdites premières régions (60) et adjacente auxdites troisièmes régions (64), ladite région de connexion comprenant au moins une ligne de bits (70), ladite ligne de bits dans ladite région de connexion étant électriquement raccordée à l'élément conducteur (66) dans les troisièmes régions (64) par au moins une région de matériau de barrière de charge d'espace non linéaire (68) fonctionnant comme une paire de diodes montées dos à dos, où ladite au moins une ligne de bits (70) interconnecte toutes les régions du matériau de barrière de charge d'espace non linéaire (68) à un bus de données commun et où chaque élément conducteur (66) dans ladite troisième région (64) est indépendamment accédé par des lignes de bits respectives (62).

2. Le dispositif semiconducteur de la revendication 1 dans lequel ladite ligne de bits (70) dans ladite région de connexion, est connectée à au moins un dispositif de commutation semiconducteur formé comme une partie d'un circuit d'accès de mémoire semiconductrice.

3. Le dispositif semiconducteur de la revendication 2 dans lequel ledit dispositif de commutation est connecté à l'extrémité de ladite ligne de bits (70) la plus éloignée de ladite surface dudit substrat.

4. Le dispositif semiconducteur de l'une ou de plusieurs des revendications précédentes 1 à 3, dans lequel ladite région de connexion est en symétrie miroir autour d'un axe orthogonal audit premier plan et lesdites troisièmes régions sont en symétrie de rotation autour dudit axe.

5. Le dispositif semiconducteur de l'une ou de plusieurs des revendications précédentes 1 à 3 dans lequel ledit premier matériau comprend un matériau semiconducteur contenant du silicium.

6. Le dispositif semiconducteur de l'une ou de plusieurs des revendications précédentes 1 à 5 dans lequel ladite première région (60) comprend du matériau semiconducteur lourdement dopé et ladite deuxième région (62) comprend du matériau semiconducteur pratiquement intrinsèque ou légèrement dopé, où ledit matériau semiconducteur contient du silicium cristallin.

7. Le dispositif semiconducteur de la revendication 6 dans lequel ledit matériau semiconducteur est dopé avec une impureté de type p- comprenant du bore.

8. Le dispositif semiconducteur de l'une ou de plusieurs des revendications précédentes 1 à 7, dans lequel les épaisseurs desdites premières (60) et deuxièmes (62) régions sont inférieures à approximativement 100 nm.

9. Le dispositif semiconducteur de l'une ou de plusieurs des revendications précédentes 1 à 8 dans lequel la portée desdites troisièmes régions (64) entre lesdites premières régions planes adjacentes (60) est supérieure de plus de dix fois à l'épaisseur desdites deuxièmes régions (62).

10. Le dispositif semiconducteur de l'une ou de plusieurs des revendications précédentes 1 à 8 dans lequel ledit substrat (10) comprend un substrat semiconducteur cristallin orienté de façon que ledit premier plan soit parallèle au plan <100> dudit substrat (10).

11. Le dispositif semiconducteur de l'une ou de plusieurs des revendications précédentes 1 à 10 dans lequel lesdits premier et second matériaux sont du matériau semiconducteur cristallin obtenu par croissance épitaxiale sur ledit substrat (10) et lesdites troisièmes régions (64) comprennent des frontières se terminant sur des plans <111>.

12. Une méthode de fabrication d'un dispositif DRAM semiconducteur tridimensionnel selon une ou plusieurs des revendications précédentes 1 à 11, sur la surface d'un substrat (10) dont la surface est parallèle à un premier plan, comprenant les étapes suivantes:
    - la formation d'une pluralité de premières (60) et de deuxièmes (62) couches imbriquées d'un premier et d'un second matériau sur ladite surface parallèle audit premier plan, lesdites deuxièmes couches formant des lignes de mots;
    - la formation d'une région de connexion au travers desdites couches (60, 62) par pénétration desdites couches pratiquement orthogonalement audit premier plan;
    - la formations de régions en tranchée (64) dans lesdites deuxièmes couches (62) pratiquement parallèles audit premier plan en attaquant sélectivement et substantiellement lesdites deuxièmes couches (62) à l'exclusion desdites premières couches (60);
    - la provision d'un matériau diélectrique (65) sur les surfaces desdites régions en tranchée (64);
    - le remplissage desdites régions en tranchée (64) avec du matériau conducteur (66), ce qui forme une région de matériau de barrière à charge d'espace non linéaire (68) aux extrémités exposées du matériau conducteur, formant ainsi des structures de dispositif semiconducteur dans lesdites régions;
    - la formation d'une ligne de bits (70) dans ladite région de connexion afin de permettre auxdites structures de dispositif semiconducteur dans lesdites régions en tranchée (64), d'être électriquement connectées aux parties dudit substrat (10) à l'extérieur desdites premières et deuxièmes couches (60, 62);
    - la formation de contacts aux lignes de mots afin de permettre auxdites structures de dispositif semiconducteur d'être indépendamment accédées.

13. La méthode de la revendication 12 dans laquelle l'étape de formation d'une pluralité de premières (60) et de deuxièmes (62) couches comprend le dépôt en alternance de couches isolantes et semiconductrices comprenant le dépôt par croissance épitaxiale desdites couches et le dépôt en phase vapeur chimique à ultra basse pression desdites couches avec une pression de dépôt inférieure à 1,33 μbar.

14. La méthode de la revendication 12 ou 13 dans laquelle l'étape de formation de régions en tranchée (64) est exécutée en utilisant une solution d'attaque anisotropique pour attaquer sélectivement et substantiellement lesdites deuxièmes couches (62) à l'exclusion desdites premières couches (60).

**15.** La méthode de l'une ou de plusieurs des revendications précédentes 12 à 14 dans laquelle l'étape de formation d'une région de connexion comprend un procédé d'attaque anisotropique hautement directionnel comme l'attaque ionique réactive.

**16.** La méthode de l'une ou de plusieurs des revendications précédentes 12 à 15, comprenant la formation d'une pluralité de régions de connexion et comprenant en outre la formation d'une région de contrôle d'attaque pour permettre de déterminer la portée de la formation des régions en tranchée (64) dans lesdites deuxièmes couches (62).

**17.** La méthode de la revendication 16 dans laquelle au moins l'une des régions de connexion est associée à la région de côntrôle de façon que la région de contrôle comprenne une structure en tranchée tridimensionnelle pratiquement identique aux autres régions de connexion où au moins une dimension est inférieure à une dimension correspondante de la partie de non-contrôle de la structure.

FIG.1

FIG.2

FIG.3

FIG.4

FIG.5

FIG.14

FIG.6

EP 0 424 623 B1

FIG.7

EP 0 424 623 B1

FIG.8

88

86

84

82

80

FIG.9

90

FIG.10

92

84

FIG.11

92

FIG.12

98

84

94

96

FIG.13

98

98

99

**19**

FIG.15

878926 5KV X50.0K 600nm

FIG.16

878927 5KV X500K 60.0nm